# EUROPEAN PATENT SPECIFICATION

(11) **EP 0 313 236 B1**
(45) Date of publication and mention of the grant of the patent: **26.04.1995**
(21) Application number: 88309364.3
(22) Date of filing: 07.10.1988
(51) Int. Cl.: H05K 7/10

(54) **Chip carrier and header assembly and terminals therefor**
IC-Träger, Fassung und Kontaktierung dafür
Support de circuit intégré, son embase et ses contacts

(30) Priority: 23.10.1987 US 112792
(43) Date of publication of application: 26.04.1989
(73) Proprietor: MOLEX INCORPORATED, Lisle Illinois 60532 (US)
(72) Inventor: Colleran, Stephen A., Lisle Illinois 60532 (US); Roberts, James T., Oak Park Illinois 60302 (US); Plocek, Edward J., Lisle Illinois 60532 (US); Silbernagel, Raymond A., Naperville Illinois 60540 (US)
(74) Representative: Greenwood, John David

(56) References cited:
- EP-A- 0 137 656
- WO-A-85/05006
- DE-A- 2 533 282
- FR-A- 2 353 201
- US-A- 3 953 101
- US-A- 4 354 718

## Description

### FIELD OF THE INVENTION

This invention relates to an I.C. chip carrier assembly for an integrated circuit chip with a header into which that carrier and chip are plugable. The assembly permits the chip to be removably placed in electrical connection with conductive traces on a printed circuit board. The invention also relates to the electrically conductive box-type terminals which are mounted in the carrier to permit electrical connection between the leads of the chip and pins which are mounted in the header and which are electrically connected to the conductive traces on the printed circuit board.

### BACKGROUND OF THE INVENTION

Integrated circuit (I.C.) chips and printed circuit boards are widely employed in electronic and electromechanical devices. The environments in which I.C. chips and printed circuit boards are used are varied and expanding rapidly. Current applications of I.C. chips and printed circuit boards extend to computers and their peripheral equipment, automotive vehicles, aircraft, industrial machines, office equipment and consumer electronic devices, to name but a few.

The electrically conductive leads of the I.C. chip may be directly and permanently connected to the electrically conductive traces on the printed circuit board by, for example, soldering. However, it is often desirable to replace the I.C. chip. Furthermore, the direct and permanent connection of the leads of the I.C. chip to the printed circuit board is not well suited to automation and results in a substantially unprotected electrical and mechanical connection that can readily be damaged.

In view of the problems associated with direct mechanical and electrical connections between I.C. chips and printed circuit boards, various socket assemblies have been developed. The prior art socket may include terminals which are soldered to plated through holes and/or conductive traces on the printed circuit board. The leads of the I.C. chip then can be removably placed in electrical contact with the terminals of the socket.

Many of the prior art socket devices further employ a carrier into which the I.C. chip is received. The carrier and the socket are constructed to be engageable with one another. Thus, the leads of the I.C. chip are guided into contact with the terminals of the prior art socket as the carrier and the socket are engaged with one another. One desirable socket assembly of this general type is shown in U.S. Patent No. 4,417,777 which issued to William C. Bamford on November 29, 1983 and is assigned to the assignee of the subject invention. Other devices which employ the combination of an I.C. chip carrier and a socket are shown in U.S. Patent No. 4,354,718 which issued to Bright et al on October 19, 1982; U.S. Patent No. 4,637,670 which issued to Coller et al on January 20, 1987; U.S. Patent No. 4,547,031 which issued to Korsunsky on October 15, 1985; U.S. Patent No. 4,470,650 which issued to Lundergan on September 11, 1984 and Canadian Patent No. 1,216,644 which issued to Sadigh-behzadi on January 13, 1987.

The assembly shown in Canadian Patent No. 1,216,644 differs from the connectors shown in the other prior art references cited above in that the carrier includes terminals with which the leads of the I.C. chip are engaged. More particularly, these terminals shown in Canadian Patent No. 1,216,644 include spring fingers which are disposed to achieve single sided contact with the respective leads of the I.C. chip, such that the leads of the I.C. chip are urged by the spring fingers of the terminals into the nonconductive carrier. These points of contact between the spring fingers of the terminals and the leads of the I.C. chip are visually and physically relatively inaccessible. Thus, the quality of the individual connections cannot readily be observed and checked. Furthermore, this relative inaccessibility substantially limits the options available to permanently join the I.C. chip leads to the spring fingers of the carrier terminals. In this regard, the inaccessibility of the contact location substantially limits the soldering to vapor reflow techniques. Vapor reflow soldering methods require the assembled I.C. chip and carrier to be exposed to a selected vapor at a temperature sufficiently elevated to melt solder material previously plated to the I.C. chip leads and the carrier terminals. However, the abusive vapor environment and the elevated temperatures can readily damage the I.C. chips, and time-consuming and costly steps must be taken to minimize the probability of such damage. Furthermore, relatively expensive plastics must be employed for the carrier housing to withstand the elevated temperatures. The construction of the carrier shown in Canadian Patent No. 1,216,644 provides little protection to the I.C. chip for situations where vapor reflow soldering techniques are required.

The device shown in Canadian Patent No. 1,216,644 further includes a socket having electrically conductive pins which are joined to the conductive traces on the printed circuit board. The socket is dimensioned to receive the carrier such that portions of the carrier terminals engage the corresponding pins in the socket. The socket is dimensionally narrow compared to the carrier. As a result, any torque created as the carrier is inserted can readily tilt the narrow socket, thereby damaging the electrical connections between the socket pins and the printed circuit board. Similarly, the removal of the carrier from the socket is likely to cause a torque that will damage the connection between the narrow socket and the printed circuit board. To reduce the probability of such damage during removal of the carrier, the socket of Canadian Patent No. 1,216,644 is provided with a pair of separate pivotally mounted latches with lever portions intended to urge the carrier out of the socket. However, the presence of the large latches makes the protection of the pins difficult during the application of conformal coatings. Consequently, the commercial embodiments of the socket shown in Canadian Patent No. 1,216,644 require a separate molded plastic housing to be placed over the socket and latches while conformal coatings are applied to the connections of the socket to the printed circuit board. This costly housing serves no other function and is later discarded.

In view of the above, it is an object of the subject invention to provide a more efficient, reliable and effective carrier and socket or header assembly for mounting I.C. chips to a printed circuit board.

An additional object of the subject invention is to provide carrier terminals that can achieve improved electrical connection to both the I.C. chip leads and to the header pins.

### SUMMARY OF THE INVENTION

The subject invention as claimed in one aspect, is directed to an I.C. chip carrier assembly comprising: a chip carrier; a plurality of box-type carrier terminals mounted in the carrier; a cover lockingly engageable with the carrier to cover and protect a chip mounted therein; and a header for mounting on a printed circuit board and constructed to receive and engage the carrier.

The header of the subject assembly may be of generally box shaped configuration with a bottom wall and upstanding side walls connected to and extending from the bottom wall to define a socket for receiving a portion of the carrier. The bottom wall may comprise a plurality of apertures through which pins extend. The dimensions of the pins and the apertures may be selected to achieve a secure mechanical force fit therebetween. Each pin may be disposed to extend from both sides of the bottom wall of the header. The magnitude of the extension of the pins from the bottom side of the bottom wall may be selected to facilitate the electrical connection of the pins to conductive traces on the printed circuit board. The bottom wall of the header may further be provided with downwardly extending standoffs to permit visual inspection of the connections of the pins to the printed circuit board, to facilitate soldering and subsequent board washing, and to enhance the application of conformal coatings. The pins preferably extend from the top surface of the bottom wall of the header a distance less than the height of the side walls of the header. Thus, an inexpensive disposable plastic film or tape may be disposed over the side walls of the header to protect the pins and prevent unintended intrusion of flux and conformal coatings applied during the assembly process. The header may further comprise means for locking the carrier therto.

The carrier also may be of generally box shaped configuration with a bottom wall and upstanding side walls. The bottom wall of the carrier may include an array of receptacles therein dimensioned to receive carrier terminals. The receptacles may extend into the top face of the bottom wall and entirely through to the bottom face of the bottom wall. Additionally, each aperture may extend to a side face of the carrier thereby permitting visual inspection and physical access to the carrier terminals from three sides of each terminal. This access increases the options available for soldering the I.C. chip leads to the terminals and makes computer scanning an option for quality control. The carrier and the header may include polarization means to ensure proper orientation therebetween.

Each receptacle of the carrier lockingly receives a carrier terminal designed to securely receive both the pins of the header and the leads of the I.C. chip. More particularly, the subject invention as claimed in another aspect is directed to a double female box-type terminal of a configuration, which effectively defines a first three-sided box to substantially surround and redundantly engage the corresponding I.C. chip lead and a second four-sided box to substantially surround and redundantly engage the corresponding header pin. The pin-engaging second female portion of the carrier terminal may include a pair of opposed inwardly directed contact beams to engage opposite sides of the associated header pin preferably at different axial locations along the pin. The first female portion of the carrier terminal may include a contact beam dimensioned to urge the I.C. chip lead into the opposed wall of the carrier terminal to again achieve a double sided redundant contact. Portions of the carrier terminal may include apertures therethrough to enable direct contact with a heater or solder tip to enable non-vapor reflow soldering of the I.C. chip lead to the carrier terminal. This option avoids the need to expose the I.C. chip and carrier to the harsh environment inherent to vapor reflow soldering methods and enables less expensive plastic to be used in molding the carrier. The above described accessibility to the carrier terminal provided by the unique carrier construction further facilitates this non-vapor reflow soldering method. However, the terminals and the chip leads can be connected by vapor phase reflow soldering provided that an appropriate heat resistant plastic is employed for the carrier. Furthermore, in certain non-vibration environments, the forces exerted between the contact beam and the opposed wall of the terminal will provide a high quality electrical connection with the chip lead, and soldering can be avoided.

The assembly further comprises a cover dimensioned to at least partly enclose the portion of the carrier in which the I.C. chip is placed and to be lockingly engaged with the carrier. The cover further includes latch arms on opposed ends thereof to engage with corresponding locking structures on the header. Thus, the cover is lockingly engageable with the carrier to define a plugable carrier subassembly.

The cover then enables the locking engagement of the carrier subassembly to the header. The latch arms which attach the cover/carrier subassembly to the header are disposed at opposite ends of the cover and may be constructed to achieve single-handed disengagement of the carrier subassembly from the header. Thus, the cover/carrier subassembly with the chip securely engaged therein can readily be disengaged from the header with a single hand and without creating potentially damaging torques on the electrical connections within the assembly. Additionally, the cover protects the I.C. chip against certain types of electrostatic discharge that could create shorts and damage or destroy the chip.

One way of carrying out the present invention in each of its aspects will now be described in detail by way of example with reference to drawings which illustrate one specific embodiment.

### BRIEF DESCRIPTION OF THE DRAWINGS

FIG. 1 is an exploded perspective view of an I.C. chip carrier assembly in use with an I.C. chip and a printed circuit board.

FIG. 2 is a perspective view of the I.C. chip carrier assembly mounted on a printed circuit board.

FIG. 3 is a cross-sectional view taken along line 3-3 of FIG. 2.

FIG. 4 is a top plan view of the carrier of the assembly.

FIG. 5 is a bottom plan view of the carrier of the assembly.

FIG. 6 is a front elevational view of the carrier of the assembly.

FIG. 7 is an end elevational view of the carrier of the assembly.

FIG. 8 is a perspective view of a terminal of the present invention.

FIG. 9 is a top plan view of the terminal shown in FIG. 8.

FIG. 10 is a cross-sectional view along line 10-10 in FIG. 9.

FIG. 11 is a front elevational view of the cover of the assembly.

FIG. 12 is a top plan view of the cover shown in FIG. 11.

FIG.13 is a bottom plan view of the cover shown in FIGS. 11 and 12.

FIG. 14 is an end elevational view of the cover.

FIG.15 is a cross-sectional view of the cover taken along lines 15-15 in FIG. 13.

### DETAILED DESCRIPTION OF THE ILLUSTRATED EMBODIMENTS

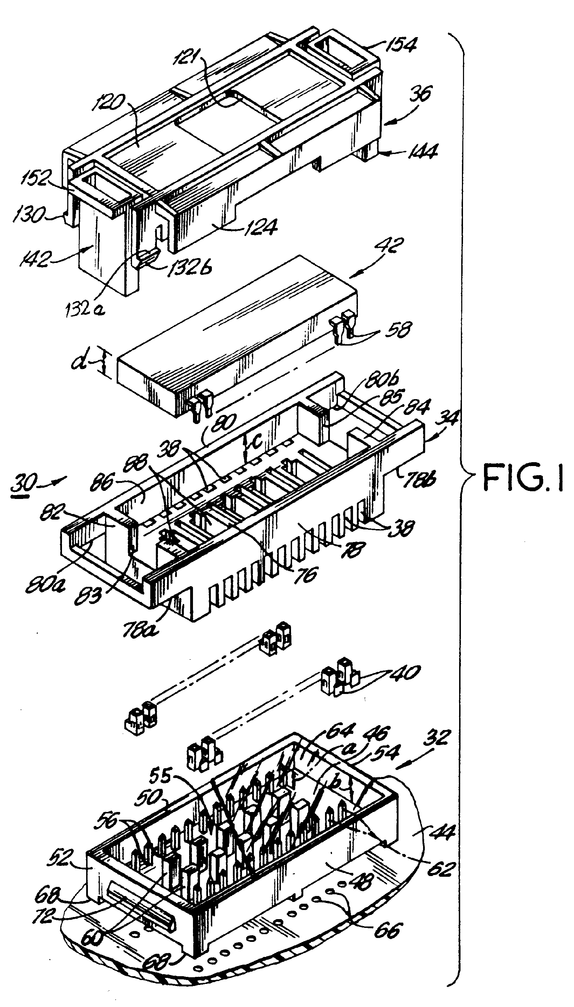

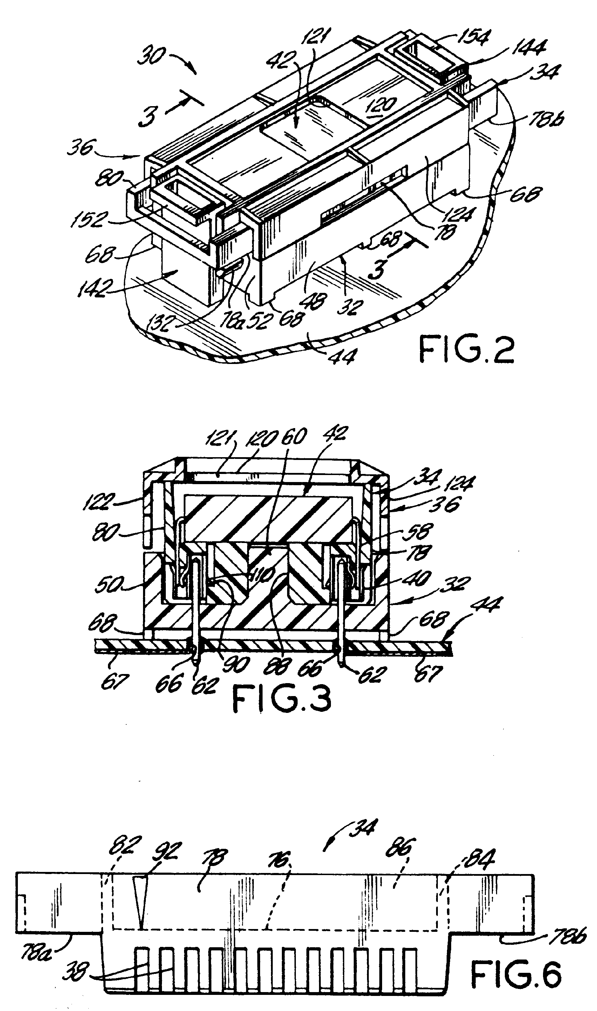

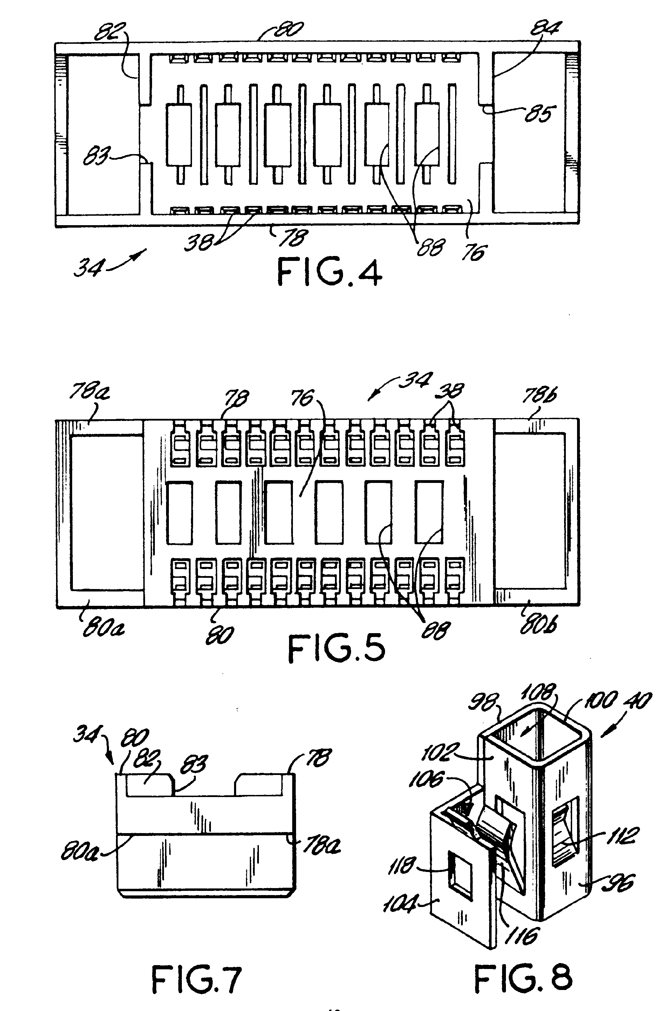

The chip carrier assembly is shown in FIGS. 1-3 and is identified generally by the numeral 30. As shown most clearly in FIGS. 1 and 3, the chip carrier assembly 30 comprises a header 32, a carrier 34 and a cover 36. The carrier 34 includes a plurality of receptacles 38 each of which is dimensioned to lockingly receive a box-type double female carrier terminal 40. The carrier 34 is further constructed to receive an I.C. chip 42 as explained in greater detail below. The entire assembly 30, and specifically the header 32 is intended for mounting on a printed circuit board indicated generally by the numeral 44.

The header 32 is of generally rectangular box-shaped configuration and is molded from an integral unitary piece of plastic material. The particular type of plastic is selected to achieve heat deflection and chemical resistance appropriate for the soldering processes used to connect the pins of the header 32 to the printed circuit board 44. For example,a glass-filled P.E.T. may be selected if wave flow soldering is to be employed. However, if the header 32 is to be subjected to a vapor phase reflow soldering environment, it may be necessary to employ a plastic with higher temperature resistance, such as a liquid crystal polymer.

The header 32 is molded to comprise a generally planar bottom wall 46, upstanding generally parallel side walls 48 and 50 and upstanding generally parallel end walls 52 and 54. More particularly, the side walls 48 and 50 and the end walls 52 and 54 are connected to and extend from the bottom wall 46 and are further connected to one another to define a socket area 55 for receiving the carrier 34, as explained in greater detail below.

The bottom wall 46 of the header 32 is further characterized by a plurality of apertures 56 extending entirely therethrough and disposed to define an array which corresponds to the orientation of the leads 58 extending from the I.C. chip 42. In the embodiment depicted in the figures hereto, the apertures 56 extending through the bottom wall 46 of header 32 are disposed to define two parallel rows of apertures corresponding to the two parallel rows of leads 58 extending from the I.C. chip 42. Other arrays may be employed with chips of different configurations. The header 32 is further characterized by polarization keys 60 which extend from the bottom wall 46 and ensure proper orientation and selection of the carrier 34 relative to the header 32.

A plurality of electrically conductive pins 62 extend through the apertures 56 in the bottom wall 46 of header 32. More particularly, the pins have a cross section which is dimensionally greater than the initial dimensions of the apertures 56. Thus, the pins 62 are in an interference fit around the entire periphery of the apertures 56 to ensure that the bottom wall 46 of header 32 is sealed to eliminate flux and conformal coating intrusion into the socket area 55 of the header 32. The pins 62 extend upwardly from the bottom wall 46 a distance "a" which is less than the height "b" of the side walls 48, 50 and end walls 52 and 54. As a result, a protective tape or film 64 is initially extended across and connected to the side walls 48, 50 and end walls 52 and 54 to protect the socket area 55 defined thereby, including the pins 62 from conformal coating, and the like, thereby avoiding the time-consuming and costly steps associated with cleaning the areas of the pins 62 to be contacted by the carrier terminals 40. The protective tape or film 64 is extremely inexpensive, is easy to apply and is easy to remove. As a result, this embodiment is substantially less expensive than prior art carrier assemblies requiring a separate molded plastic disposable housing to protect the pins. Typically, the pins 62 are inserted and the tape 64 applied at the place of manufacture of header 32, so that the consumer receives an assembled and protected header. However, the tape may be applied at other times, such as after the pins 62 are soldered to the board 44, and after the board 44 is washed, but prior to the application of the conformal coating.

As noted above, the header 32 is mounted to a printed circuit board 44. More particularly, the printed circuit board 44 is provided with arrays of plated through holes 66 extending therethrough. The plating disposed at the through holes 66 communicates with conductive traces 67 on the printed circuit board 44. The pins 62 extend from the bottom side of the bottom wall 46 of header 32 a sufficient distance to enter the plated through holes 66. The pins then are mechanically and electrically connected to the plated through holes 66 by, for example, wave soldering or by vapor reflow soldering techniques. In other embodiments, the holes 66 are not plated, and the pins 62 are soldered directly to the conductive traces 67. To facilitate this soldering and enable visual inspection of the connections, the header 32 is provided with an array of standoffs 68 which function to space the bottom wall 46 of header 32 slightly from the printed circuit board 44. After this soldering has been completed, a conformal coating will be applied by dipping or other means to protect the electrical connection between the pins 62 and the plated through hole 66. The standoffs facilitate the application of this conformal coating, while the tape 64 protects the portion of pins 62 above the bottom wall 46 from both the conformal coating and flux.

The header 32 further includes a pair of latch wings 72 and 74 unitary with the end walls 52 and 54 respectively. The latch wings 72 and 74 will enable the subassembly comprising the carrier 34, the cover 36 and the I.C. chip 42 to be lockingly but removably engaged to the header 32, as explained further below.

The carrier 34 also is of generally rectangular configuration and is molded from a unitary piece of plastic material. As noted above, and as explained in greater detail below, the carrier 34 and the terminals 40 of the subject invention are particularly constructed to enable non-vapor reflow solder connection of the leads 58 of I.C. chip 42 to the carrier terminals 40. In these situations, the entire carrier 34 is not subjected to the high heat environment associated with vapor reflow soldering techniques. As a result, a plastic material, such as glass-filled P.E.T., can be used for the carrier 34. of the carrier is to be subject to the vapor reflow soldering environment, the carrier 34 and the cover 36 would have to be formed from a heat resistant and substantially more expensive plastic material such as liquid crystal polymer. If the chip leads are not to be soldered to the terminals, such as in certain computer applications, the carrier 34 and cover 36 may be formed from an inexpensive material such as nylon.

The carrier 34 is of generally rectangular configuration and includes a bottom wall 76, a pair of parallel upstanding side walls 78 and 80 and a pair of parallel upstanding end walls 82 and 84. The side walls 78, 80 and end walls 82, 84 define a protective chip receiving recess 86 which is dimensioned to receive the I.C. chip 42. More particularly, the side walls 78 and 80 and end walls 82 and 84 have a height "c" which exceeds the height "d" of chip 42 as shown in FIG. 1. Thus, the chip 42 is never contacted by the cover 36. . The end walls 82 and 84 further include access slots 83 and 85 to facilitate removal of chip 42 if necessary.

The bottom wall 76 of the carrier 34 is characterized by a plurality of polarization apertures 88 which are disposed and dimensioned to engage the polarization keys 60 on header 32. Additionally, as noted above, the carrier 34 includes arrays of terminal receptacles 38. The terminal receptacles 38 are formed to receive the leads 58 of the I.C. chip 42, and are formed with a tapered lead-in to facilitate robotic assembly with the chip 42. Additionally, the receptacles 38 extend entirely through the bottom wall 76 of the carrier 34 to provide visual and physical access to the carrier terminals both from the top of the bottom wall 76, from the bottom of the bottom wall 76 and from the respective sides of the carrier 34. This construction achieves several important objectives. First, non-vapor soldering means can be employed to join the 1.C. chip leads 58 to the carrier terminals 40. Second, the soldered connection is visually observable from three sides to enable the use of computer scanning devices for quality control. Third, the side access to each receptacle 38 achieves probeability for electrically testing the chip lead connections.

As shown most clearly in FIG. 3, each receptacle 38 includes an internal locking ledge 90 which securely and positively engages a portion of the carrier terminals 40, as explained further below. Additionally, as shown in both FIGS. 1 and 3, the bottom and side access areas of each aperture 38 are larger than the corresponding access at the top side of bottom wall 76. This construction ensures a carefully controlled and guided alignment of the I.C. chip leads 58 into the carrier terminals 40 as explained further below. The configuration of each receptacle 38 positively controls the position and alignment of the carrier terminals 40.

The carrier side walls 78 and 80 extend beyond the respective end walls 82 and 84 to define locking surfaces 78a, 78b, 80a and 80b. As explained further below, the locking surfaces 78a, b and 80a, b enable the locking engagement between the carrier 34 and cover 36 to define a carrier subassembly as explained below. The side wall 78 of the carrier 34 is further provided with an indicator 92 to clearly identify pin number one. The indicator 92 will clearly identify the proper orientation of the carrier 34 relative to the header 32 and the printed circuit board 44 thereby avoiding trial and error insertion and complete reliance on the polarization keys 58 and polarization apertures 88.

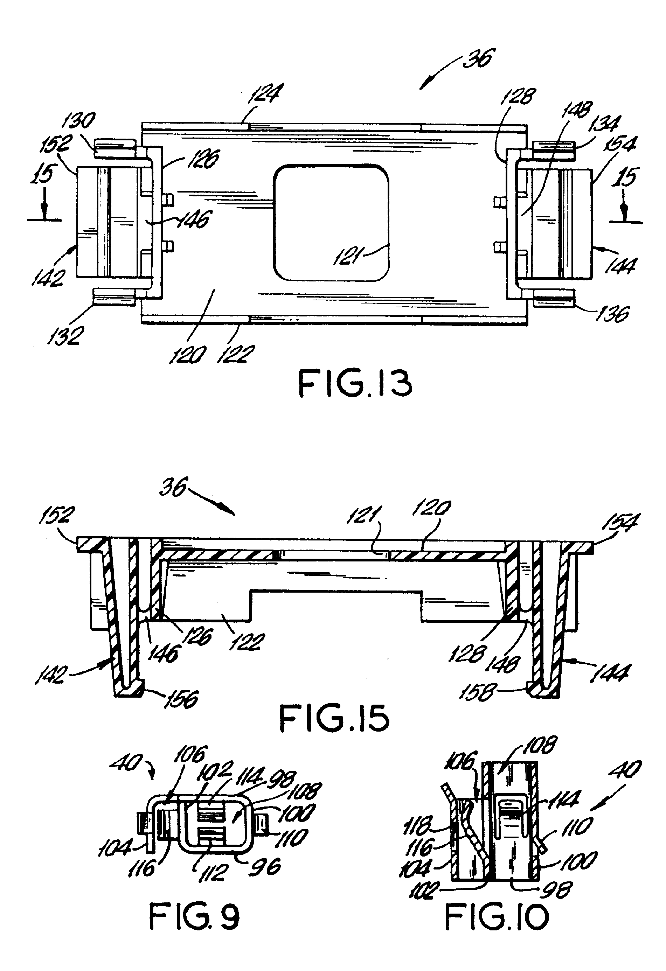

The carrier terminals 40 are depicted relative to the other components of the assembly 30 in FIGS. 1 and 3, and are depicted alone in FIGS. 8-10. Each carrier terminal 40 comprises opposed parallel end walls 96 and 98, a first wall 100 extending orthogonally between and connecting the end walls 96 and 98, an intermediate wall 102 parallel to the first wall 100 and extending from the end wall 96, and a second wall 104 extending from the end wall 98 and parallel to the first wall 100. The resulting terminal structure effectively defines a box-type first female socket portion 106 to receive a lead 58 and a generally box-type second female socket portion 108 to receive a pin 62.

The carrier terminal 40 is further stamped to define a locking lance 110 extending from the first wall 100 and disposed to lockingly engage the ledge 90 in the corresponding receptacle 38 of the carrier 34. The second socket portion 108 is further characterized by a pair of inwardly extending cantilevered contact beams 112 and 114. The contact beam 112 is longer than the contact beam 114 to ensure that the respective contact beams 112 and 114 mate with the associated pins 62 at different axial locations therealong. These different lengths of the contact beams 112 and 114 prevent intermittancy that could otherwise result from vibrations in the environment in which the carrier assembly 30 is employed.

The intermediate wall 102 is characterized by a cantilevered contact beam 116 which extends toward the second wall 104. More particularly, the cantilevered contact beam 116 extends convexly into the first socket portion 106 to achieve a broad contact area with the associated I.C. chip lead 58, and to urge the lead 58 against the second wall 104, thereby achieving a two-sided redundant contact covering a large area of lead 58. The second wall 104 of the carrier terminal 40 lies generally opposite the cantilevered contact beam 116, and is characterized by a window 118 disposed generally in line with the contact beam 116. The window 118 facilitates the direct application of a heater tip or solder tip to the area of contact between the contact beam 116 and the corresponding I.C. chip lead 58 to enable reflow soldering therebetween. However, the window 118 can be provided on embodiments where vapor phase reflow soldering is employed, or where no soldering is required.

The terminal 40 is selectively plated to achieve the preferred performance and electrical connections. More particularly, the entire terminal 40 preferably is plated with nickel. However, the contact beam 116 preferably is plated with solder to achieve the reflow soldering explained above upon the application of heat thereto. In embodiments of the subject invention employing vapor phase reflow soldering, both the contact beam 116 and the facing surface of the second wall 104 may be solder plated to achieve a two-sided redundant connection. The contact beams 112 and 114 of course will not be soldered to pins 62, but a high quality and repeatable electrical connection is required. To positively protect against corrosion the contact beams 112 and 114 preferably are coated with gold.

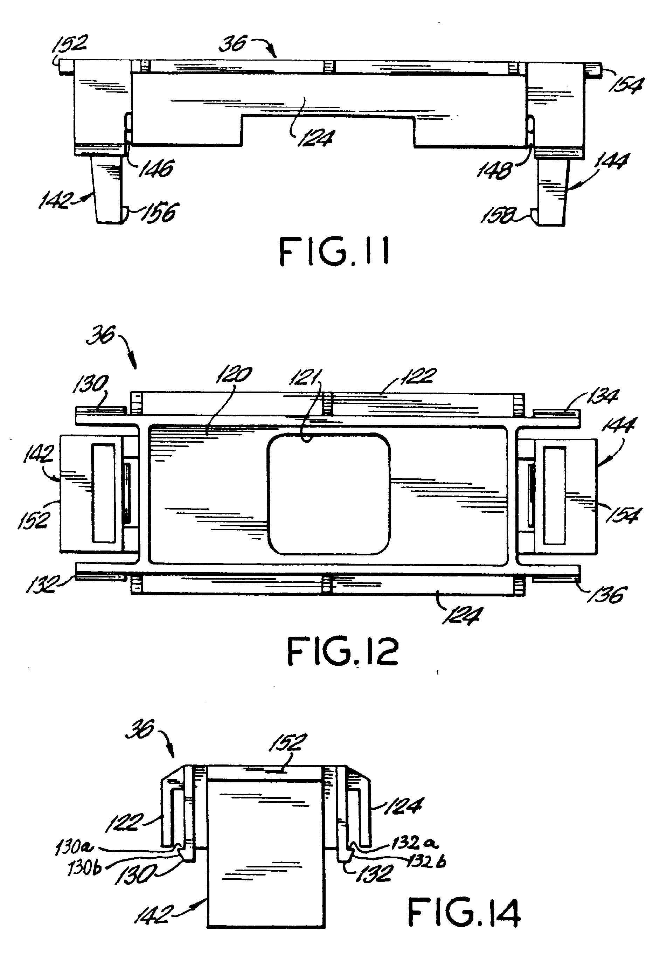

The cover 36 is constructed to perform two distinct functions. In particular, the cover 36 is constructed to lockingly engage with the carrier 34 to cover and protect the I.C. chip 42 and to thereby define a plugable subassembly. Second, the cover 36 is constructed to lockingly but releasably engage the subassembly with the header 32 such that convenient one-hand removal from the locked condition on the header 32 is possible. With reference to FIGS. 1-3 and 11-15, the cover 36 includes a top wall 120 dimensioned to extend substantially across the chip recess 86 of the carrier 34. However, the cover 36 is shown with an optional window 121 to enable visual inspection and identification of chip 42. Furthermore, as shown in FIG. 3, the carrier prevents direct and potentially damaging contact between the top wall 120 and chip 42.

The cover 36 further comprises a pair of opposed parallel side walls 122 and 124 and a pair of opposed parallel end walls 126 and 128, all of which extend orthogonally from the top wall 120. However, the side walls 122 and 124 are spaced from the end walls 126 and 128. The side walls 122 and 124 and the end walls 126 and 128 are disposed to enable the cover 36 to be telescopingly engaged over the carrier 34. More particularly, the portions of the carrier side walls 78 and 80 which extend beyond the carrier end walls 82 and 84 slide into the spaces between the cover side walls 122 and 124 and the cover end walls 126 and 128. The cover end walls 126 and 128 also cover the access slots 83 and 85 in carrier 34.

The cover 36 further includes locking latches 130 and 132 extending downwardly from the end wall 126 and locking latches 134 and 136 extending downwardly from the end wall 128. The locking latches 130-136 are generally parallel to the side walls 122 and 124 of cover 36, and include locking ledges 130a-136a which are disposed to engage the locking surfaces 78a, 78b and 80a, 80b on the carrier 34. The locking latches 130-136 are further characterized by ramps 130b-136b which effectively guide the locking latches 130-136 into engagement with the locking surfaces 78a, 78b and 80a, 80b, thereby facilitating robotic assembly of the cover 36 to the carrier 34.

The cover 36 further includes subassembly latch arms 142 and 144 which are connected to the respective end walls 126 and 128 at locations 146 and 148 respectively. The connection of the subassembly latch arms 142 and 144 to the end walls 126 and 128 is disposed at locations approximately midway along the length of each subassembly latch arm 142, 144. The uppermost portion of each subassembly latch arm 142, 144 is substantially in line with the top wall 120, and defines latch arm actuators 152 and 154. The ends of the latch arms 142 and 144 remote from the actuators 152 and 154 define locking ledges 156 and 158 which are facing one another and which are disposed to engage the latch wings 72 and 74 on the header 32. When the actuators 152 and 154 are urged toward one another by, for example, pressure exerted by a thumb and forefinger, the locking ledges 156 and 158 at the opposed ends of the respective latch arms 142 and 144 will rotate away from one another. Both the locking ledges 156 and 158 and the latch wings 72 and 74 are ramped to provide large convenient lead-ins which facilitate robotic plugable mating of the combined subassembly of the cover 36 and carrier 34 to the header 32.

In the typical installation, the pins 62 are forced into the apertures 56 in the header 32 to achieve an interference fit that prevents intrusion of flux and conformal coatings into the socket 55. The protect tape 64 is then applied to further protect the socket 55. The assembled header 32 is then sold to the user. The header 32 is then positioned on the printed circuit board 44 such that the pins 62 extend through the plated through holes 66 in the printed circuit board 44. The pins 62 are then electrically connected to the plated through holes 66 by, for example, wave flow soldering techniques. A conformal coating is then applied to the area of the electrical connections between the pins 62 and the plated through holes 66. The tape 64 covering the header 32 prevents any conformal coating material from being deposited within the header 32. However, after a complete application of the conformal coating, the tape 64 may be removed for subsequent assembly steps.

The carrier terminals 40 are mounted in the carrier 34 by urging upwardly from the bottom side of the carrier 34, until the locking lances 110 are locked in the respective ledges 90 of receptacles 38. The I.C. chip 42 is then mounted in recess 86 of the carrier 34 such that the leads 58 thereof advance into the ramped upper access to the respective receptacles 38. More particularly, the leads 58 are received in the terminals 40, and between the cantilevered contact beam 116 and the outer wall 104 thereof. This configuration ensures double sided redundant contact with the leads 58 of the I.C. chip 42. The I.C. chip leads 58 are then reflow soldered into position on the corresponding carrier terminals 40. The cover 36 is then locked into engagement with the carrier 34 to enclose and protect the I.C. chip 42 and to define a plugable subassembly which is then urged into plugged engagement with the header 32. This plugged engagement of the carrier subassembly with the header 32 ensures that the respective pins 62 are received within the terminals 40 with double sided redundant electrical connection by the cantilevered spring loaded contact beams 112 and 114. The subassembly of the carrier 34 and cover 36 is locked into engagement by the latch arms 142 and 144 which snap into engagement with the ramped latch wings 72 and 74. This subassembly may subsequently be removed from the header 32 with one hand, by merely urging actuators 152 and 154 of the latch arms 142 and 144 toward one another to ensure disengagement of the ledges 156 and 158 from the header latch wings 72 and 74.

There has been described with reference to the drawings an I.C. chip carrier assembly wherein the soldered connection between the I.C. chip leads and the corresponding carrier terminals can be inspected visually. The assembly achieves an extremely effective electrical connection between the chip leads and the carrier terminals and between the carrier terminals and header pins. A header provides a sturdy mechanical base against the printed circuit board and selected portions of the header pins can readily and inexpensively be protected from undesirable intrusion from conformal coatings and flux. The carrier protective cover performs a redundant locking function by locking itself to the carrier and by releasably locking the carrier to the header. The assembly facilitates and enables the removal of the carrier and chip with one hand and without creating torques within the assembly. The assembly enables either vapor phase reflow soldering or non-vapor reflow soldering of the I.C. chip leads to the carrier terminals.

## Claims

1. An I.C. chip carrier assembly (30) for an I.C. chip (42) having a plurality of electrically conductive leads (58) extending therefrom, said assembly having:
a chip carrier (34) comprising a bottom wall (76) having a plurality of receptacles (38) extending therethrough, said receptacles being disposed to be generally in register with the leads of the I.C. chip;
a plurality of box-type carrier terminals (40) mounted respectively in each of said carrier receptacles, each said carrier terminal comprising first and second female terminal portions (106, 108), with the first female portion of each said carrier terminal being disposed to receive one said I.C. chip lead;
a cover (36) dimensioned and configured for locking engagement to said carrier to define a carrier subassembly (34, 36), said cover further comprising a pair of subassembly latch arms (142, 144) connected to and extending therefrom: and
a header (32) for mounting to a printed circuit board (44), said header comprising a bottom wall (46) having a plurality of electrically conductive pins (62) extending therethrough and disposed to be substantially in register with the second female portion of the respective carrier terminals, said header comprising locking means (72, 74) for lockingly engaging the subassembly latch arms of the cover to securely engage the carrier subassembly to the header.

2. An I.C. chip carrier assembly as claimed in claim 1 wherein the header further comprises a plurality of interconnected upstanding walls (48, 50, 52, 54) connected to and extending from said bottom wall (46) to define a socket (55) for receiving at least a portion of said carrier, said upstanding walls substantially surrounding the pins of said header and extending from said bottom wall a distance equal to or greater than the height of said pins.

3. An I.C. chip carrier assembly as claimed in claim 2 wherein said header further comprises a protective material (64) removably disposed in contact with said upstanding walls to substantially completely enclose the pins surrounded by said upstanding walls.

4. An I.C. chip carrier assembly as claimed in any preceding claim wherein said header further comprises a plurality of standoffs (68) connected to and extending from said bottom wall, said standoffs defining legs for spacing said bottom wall from a printed circuit board.

5. An I.C. chip carrier assembly as claimed in any preceding claim wherein the bottom wall (76) of said carrier comprises opposed top and bottom surfaces and a plurality of side surfaces, and wherein each receptable (38) thereof extends entirely through said bottom wall from the top surface thereof to the bottom surface and further extends to at least one said side surface.

6. An I.C. chip carrier assembly as claimed in any preceding claim wherein said carrier comprises a plurality of upstanding walls (78, 80, 82, 84) connected to and extending from said bottom wall thereof to define a chip recess (86) for receiving and protecting the I.C. chip.

7. An I.C. chip carrier assembly as claimed in claim 6 wherein the cover (36) comprises a top wall (120) and a plurality of side walls (122, 124, 126, 128) extending from and connected to said top wall, said side walls of said cover being disposed to be placed in generally telescoping engagement with the upstanding walls of said carrier, such that the locking engagement of the cover to the carrier substantially encloses a chip mounted in the chip recess of said carrier.

8. An I.C. chip carrier assembly as in claim 7 wherein the cover comprises a plurality of carrier latch arms (130, 132, 134, 136) connected to and extending therefrom, said carrier latch arms being disposed to lockingly engage said cover with said carrier to define a plugable subassembly.

9. An I.C. chip carrier assembly as in claim 8 wherein said subassembly latch arms (142, 144) each comprise a locking ledge (156, 158) engageable with the locking means of said header, and further comprise actuator means (152, 154) for rotating said locking ledges away from one another and out of engagement with said header, for disengaging said carrier, subassembly from said header.

10. An I.C. chip carrier assembly as claimed in any preceding claim wherein said carrier and said header comprise polarization means (60, 88) for assuring proper orientation relative to one another.

11. An I.C. chip carrier assembly as claimed in any preceding claim wherein each said carrier terminal (40) comprises a pair of opposed cantilevered contact beams (112, 114) extending into the second female portion (108) thereof for achieving double-sided redundant electrical contact with the pins (62) of said header.

12. An I.C. chip carrier assembly as claimed in claim 11 wherein the contact beams (112, 114) of said second female portion are of different respective lengths.

13. An I.C. chip carrier assembly as claimed in any preceding claim wherein each said box-type carrier terminal is formed from a unitary piece of electrically conductive material and comprises a first (100), a second wall (104) and an intermediate wall (102) disposed between said first and second wall and generally parallel thereto, a first end wall (96) connected to and extending orthogonally between said inner and outer walls and a second end wall (98) connected to and extending between said first wall and said intermediate wall such that said first female socket portion (106) is defined by said intermediate wall, said second wall and a portion of said first end wall, and wherein the second female portion (108) thereof is defined by said first wall, said intermediate wall, said second end wall and a portion of said first end wall.

14. An I.C. chip carrier assembly as claimed in claim 13, wherein each said carrier terminal comprises a cantilevered contact beam (116) extending from said intermediate wall (102) into the first female portion (106) thereof, for urging one said I.C. chip lead (58) into contact with the second wall (104) of said carrier terminal.

15. An I.C. chip carrier assembly as claimed in claim 14 wherein the second wall (104) of each said carrier terminal is characterised by an aperture (118) generally aligned with the contact beam extending into the first female portion thereof, whereby said aperture facilitates non-vapor soldering of said I.C. chip lead to said carrier terminal.

16. A box-type double female terminal (40) for connecting an I.C. chip lead (58) to an electrically conductive pin (62), said terminal being formed from a unitary piece of electrically conductive material stamp formed to define generally parallel first and second walls (100, 104), an intermediate wall (102) parallel to said first and second wall, a first end wall (96) connected to and extending orthogonally between said first and second wall and a second end wall (98) connected to and extending between said first wall and said intermediate wall, such that said intermediate wall, said second wall and a portion of said first end wall define a first female socket portion (106) of said terminal, and such that said first wall, said intermediate wall, said second end wall and a portion of said first end wall define a second female portion (108) of said terminal.

17. A terminal as claimed in claim 16 further comprising cantilevered contact beams (112, 114) extending toward one another and into said second female portion of said terminal from the first and second end walls respectively.

18. A terminal as claimed in claim 17 wherein the first and second contact beams extending into said second female portion are of different respective lengths.

19. A terminal as claimed in claim 16 comprising a cantilevered contact beam (116) extending from said intermediate wall convexly into said first female portion of said terminal for urging an I.C. chip lead into contact with the second wall of said terminal.

20. A terminal as claimed in claim 19 wherein the second wall of said terminal is characterized by an aperture (118) generally aligned with the contact beam extending into the first female portion thereof for facilitating non-vapor soldering of an I.C. chip lead to said terminal.

21. A terminal as claimed in claim 20 wherein opposed portions of said second wall and said contact beam extending into said first female portion are plated with solder.

## Patentansprüche

1. IC-Chip-Trägereinheit (30) für einen IC-Chip (42) mit einer Mehrzahl von diesem ausgehender elektrisch leitender Leitungsstifte (58), bestehend aus:
einem Chipträger (34) mit einer Bodenwand (76) mit einer Mehrzahl sich durch diese hindurcherstreckender Fassungen (38), wobei die Fassungen so angeordnet sind, daß sie allgemein mit den Leitungsstiften des IC-Chips ausgerichtet sind,
einer Mehrzahl boxartiger, jeweils in den Trägerfassungen montierter Trägeranschlüsse (40), wobei jeder Trägeranschluß einen ersten und einen zweiten Aufnahmeanschlußbereich (106,108) umfaßt, wovon der erste Aufnahmebereich jedes Trägeranschlusses so angeordnet ist, daß er einen IC-Chip-Leitungsstift aufnimmt,
einem Deckel (36), der für einen Verriegelungseingriff mit dem Träger zur Bildung einer Trägeruntereinheit (34,36) bemessen und gestaltet ist, wobei der Deckel ferner ein Paar von Untereinheitsklinkenarmen (142,144) umfaßt, die mit diesem verbunden sind und von diesem ausgehen, und
einer Fassung (32) für eine Montage an einer gedruckten Leiterplatte (44), wobei die Fassung eine untere Wand (46) mit einer Mehrzahl elektrisch leitender Stifte (62) umfaßt, die sich durch diese hindurcherstrecken und so angeordnet sind, daß sie im wesentlichen mit dem zweiten Aufnahmebereich der jeweiligen Trägeranschlüsse ausgerichtet sind, und die Fassung Verriegelungsmittel (72,74) für einen Verriegelungseingriff mit den Untereinheitsklinkenarmen des Deckels für einen sicheren Eingriff der Trägeruntereinheit mit der Fassung umfaßt.

2. IC-Chip-Trägereinheit nach Anspruch 1, bei der die Fassung ferner eine Mehrzahl miteinander verbundener aufrechter Wände (48,50,52,54) umfaßt, die mit der unteren Wand (46) verbunden sind und von dieser ausgehen, so daß eine Buchse (55) zur Aufnahme zumindest eines Bereichs des Trägers gebildet ist, und die aufrechten Wände im wesentlichen die Stifte der Fassung umgeben und sich von der unteren Wand über ein Maß erstrecken, das gleich oder größer ist als die Höhe der Stifte.

3. IC-Chip-Trägereinheit nach Anspruch 2, bei der die Fassung ferner ein Schutzmaterial (64) umfaßt, das abnehmbar in Berührung mit den aufrechten Wänden angebracht ist, um die von den aufrechten Wänden umgebenen Stifte im wesentlichen vollständig einzuschließen.

4. IC-Chip-Trägereinheit nach einem beliebigen vorhergehenden Anspruch, bei der die Fassung ferner eine Mehrzahl von Abstandhaltern (68) umfaßt, die mit der unteren Wand verbunden sind und von dieser ausgehen, wobei die Abstandhalter Füße zum Beabstanden der unteren Wand von einer gedruckten Leiterplatte bilden.

5. IC-Chip-Trägereinheit nach einem beliebigen vorhergehenden Anspruch, bei der die Bodenwand (76) des Trägers eine obere und eine gegenüberliegende untere Oberfläche und eine Mehrzahl von Seitenflächen umfaßt, wobei sich dessen Fassungen (38) jeweils ganz durch die Bodenwand von deren oberer Oberfläche zu der unteren Oberfläche erstrecken und sich ferner zu zumindest einer Seitenfläche erstrecken.

6. IC-Chip-Trägereinheit nach einem beliebigen vorhergehenden Anspruch, bei der der Träger eine Mehrzahl aufrechter Wände (78,80,82,84) umfaßt, die mit dessen Bodenwand verbunden sind und von dieser ausgehen, um eine Chipausnehmung (86) zur Aufnahme und zum Schutz des IC-Chips zu bilden.

7. IC-Chip-Trägereinheit nach Anspruch 6, bei der der Deckel (36) eine obere Wand (120) und eine Mehrzahl von Seitenwänden (122,124,126, 128) umfaßt, die von der oberen Wand ausgehen und mit dieser verbunden sind, wobei die Seitenwände des Deckels so angeordnet sind, daß sie im Prinzip in einen Teleskopeingriff mit den aufrechten Wänden des Trägers bringbar sind, derart, daß durch den Verriegelungseingriff des Deckels mit dem Träger ein in der Chipausnehmung des Trägers montierter Chip im wesentlichen umschlossen ist.

8. IC-Chip-Trägereinheit nach Anspruch 7, bei der der Deckel eine Mehrzahl von Trägerklinkenarmen (130,132,134,136) umfaßt, die mit diesem verbunden sind und von diesem ausgehen, wobei die Trägerklinkenarme so angeordnet sind, daß sie den Deckel mit dem Träger zur Bildung einer steckbaren Untereinheit in Verriegelungseingriff bringen.

9. IC-Chip-Trägereinheit nach Anspruch 8, bei der die Untereinheitsklinkenarme (142,144) jeweils eine mit den Verriegelungsmitteln der Fassung in Eingriff bringbare Verriegelungsleiste (156,158) und ferner Betätigungsmittel (152,154) zum Drehen der Verriegelungsleisten voneinander fort und außer Eingriff mit der Fassung zum Lösen der Trägeruntereinheit von der Fassung umfassen.

10. IC-Chip-Trägereinheit nach einem beliebigen vorhergehenden Anspruch, bei der der Träger und die Fassung Polarisierungsmittel (60,88) zur Gewährleistung der richtigen Ausrichtung relativ zueinander umfassen.

11. IC-Chip-Trägereinheit nach einem beliebigen vorhergehenden Anspruch, bei der jeder Trägeranschluß (40) ein Paar gegenüberliegender vorkragender Kontaktleisten (112,114) umfaßt, die sich in seinen zweiten Aufnahmebereich (108) zur Erzielung eines doppelseitigen redundanten elektrischen Kontakts mit den Stiften (62) der Fassung hineinerstrecken.

12. IC-Chip-Trägereinheit nach Anspruch 11, bei der die Kontaktleisten (112,114) des zweiten Aufnahmebereichs von unterschiedlicher jeweiliger Länge sind.

13. IC-Chip-Trägereinheit nach einem beliebigen vorhergehenden Anspruch, bei der jeder boxartige Trägeranschluß als eine Stückeinheit aus elektrisch leitendem Material gebildet ist und eine erste Wand (100), eine zweite Wand (104) und eine zwischen der ersten und zweiten Wand angeordnete und im allgemeinen parallel zu dieser verlaufende Zwischenwand (102), eine mit der inneren und der äußeren Wand verbundene und rechtwinklig zwischen diesen verlaufende erste Endwand (96) und eine mit der ersten Wand und der Zwischenwand verbundene und zwischen diesen verlaufende zweite Endwand (98) umfaßt, derart, daß der erste Aufnahmebuchsenbereich (106) von der Zwischenwand, der zweiten Wand un einem Bereich der ersten Endwand gebildet ist, und wobei sein zweiter Aufnahmebereich (108) von der ersten Wand, der Zwischenwand, der zweiten Endwand und einem Bereich der ersten Endwand gebildet ist.

14. IC-Chip-Trägereinheit nach Anspruch 13, bei der jeder Trägeranschluß eine vorkragende Kontaktleiste (116) umfaßt, die sich von der Zwischenwand (102) in seinen ersten Aufnahmebereich (106) erstreckt, um einen IC-Chip-Leitungsstift (58) in Kontakt mit der zweiten Wand (104) des Trägeranschlusses zu drükken.

15. IC-Chip-Trägereinheit nach Anspruch 14, bei der die zweite Wand (104) jedes Trägeranschlusses gekennzeichnet ist durch eine Öffnung (118), die im allgemeinen mit der sich in dessen ersten Aufnahmebereich hineinerstreckenden Kontaktleiste ausgerichtet ist, wodurch die Öffnung ein Nicht- Dampf-Verlöten des IC-Chip-Leitungsstiftes mit dem Trägeranschluß begünstigt.

16. Boxartiger Doppelaufnahmeanschluß (40) zur Verbindung eines IC-Chip-Leitungsstiftes (58) mit einem elektrisch leitenden Anschlußstift (62), wobei der Anschluß von einem Einheitsstück einer elektrisch leitenden Materialstanzung gebildet ist, das so geformt ist, daß es eine erste und eine zweite Wand (100, 104) im allgemeinen parallel zueinander, eine Zwischenwand (102) parallel zu der ersten und der zweiten Wand, eine mit der ersten und der zweiten Wand verbundene und rechtwinklig zwischen diesen verlaufende erste Endwand (96) und eine mit der ersten Wand und der Zwischenwand verbundene und zwischen diesen verlaufende zweite Endwand (98) bildet, derart, daß die Zwischenwand, die zweite Wand und ein Bereich der ersten Endwand einen ersten Aufnahmebuchsenbereich (106) des Anschlusses bilden, und derart, daß die erste Wand, die Zwischenwand, die zweite Endwand und ein Bereich der ersten Endwand einen zweiten Aufnahmebereich (108) des Anschlusses bilden.

17. Anschluß nach Anspruch 16, ferner bestehend aus vorkragenden Kontaktleisten (112,114), die sich gegeneinander und in den zweiten Aufnahmebereich des Anschlusses von der ersten bzw. der zweiten Endwand erstrecken.

18. Anschluß nach Anspruch 17, bei dem die erste und die zweite Kontaktleiste, die sich in den zweiten Aufnahmebereich hineinerstrecken, von unterschiedlicher jeweiliger Länge sind.

19. Anschluß nach Anspruch 16, mit einer vorkragenden Kontaktleiste (116), die sich von der Zwischenwand konvex in den ersten Aufnahmebereich des Anschlusses für ein Drücken eines IC-Chip-Leitungsstiftes in Kontakt mit der zweiten Wand des Anschlusses hineinerstreckt.

20. Anschluß nach Anspruch 19, bei dem die zweite Wand des Anschlusses durch eine Öffnung (118) gekennzeichnet ist, die im allgemeinen mit der sich in seinen ersten Aufnahmebereich hineinerstreckenden Kontaktleiste zur Begünstigung eines Nicht-Dampf-Verlötens eines IC-Chip-Leitungsstiftes mit dem Anschluß ausgerichtet ist.

21. Anschluß nach Anspruch 20, bei dem einander gegenüberliegende Bereiche der zweiten Wand und der sich in den ersten Aufnahmebereich hineinerstreckenden Kontaktleiste mit Lötmittel plattiert sind.

## Revendications

1. Assemblage (30) de support de puce à circuit intégré pour une puce (42) à circuit intégré ayant une pluralité de conducteurs (58) électriquement conducteurs s'étendant à partir de celle-ci, ledit assemblage comportant:
un support (34) de puce comprenant une paroi inférieure (76) ayant une pluralité de réceptacles (38) s'étendant à travers celle-ci, lesdits réceptacles étant disposés pour être en correspondance générale avec les conducteurs de la puce à circuit intégré;
une pluralité de bornes (40) de support de type tubulaire montées respectivement dans chacun desdits réceptacles de support, chacune desdites bornes de support comprenant des première et seconde parties (106, 108) de borne femelle, la première partie femelle de chacune desdites bornes de support étant disposée pour recevoir l'un desdits conducteurs de puce à circuit intégré;
un couvercle (36) dimensionné et configuré pour un engagement à verrouillage avec ledit support afin de définir un sous-assemblage de support (34, 36), ledit couvercle comportant en outre une paire de bras de verrouillage de sous-assemblage (142, 144) connectés à celui-ci et s'étendant à partir de celui-ci; et
une embase (32) pour le montage sur une carte à circuit imprimé (44), ladite embase comprenant une paroi inférieure (46) ayant une pluralité de broches électriquement conductrices (62) s'étendant à travers celle-ci et disposées pour être sensiblement en correspondance avec la seconde partie femelle des bornes de support respectives, ladite embase comprenant des moyens de verrouillage (72, 74) pour coopérer en verrouillage avec les bras de verrouillage du sous-assemblage du couvercle afin de coopérer et de fixer le sous-assemblage de support à l'embase.

2. Assemblage de support de puce à circuit intégré selon la revendication 1 dans lequel l'embase comporte en outre une pluralité de parois verticales interconnectées (48, 50, 52, 54) connectées à ladite paroi inférieure (46) et s'étendant à partir de celle-ci pour définir un socle (55) pour recevoir au moins une partie dudit support, lesdites parois verticales entourant sensiblement les broches de ladite embase et s'étendant à partir de ladite paroi inférieure sur une distance égale ou supérieure à la hauteur desdites broches.

3. Assemblage de support de puce à circuit intégré selon la revendication 2 dans lequel ladite embase comporte en outre un matériau de protection (64) disposé de manière amovible en contact avec lesdites parois verticales afin de renfermer sensiblement complètement les broches entourées par lesdites parois verticales.

4. Assemblage de support de puce à circuit intégré selon l'une quelconque des revendications précédentes dans lequel ladite embase comporte en outre une pluralité de séparateurs (68) reliés à ladite paroi inférieure et s'étendant à partir de celle-ci, lesdits séparateurs définissant des branches pour espacer ladite paroi inférieure d'une carte à circuit imprimé.

5. Assemblage de support de puce à circuit intégré selon l'une quelconque des revendications précédentes dans lequel la paro inférieure (76) dudit support comporte des surfaces supérieure et inférieure et une pluralité de surfaces latérales, et dans lequel chacun de ses réceptacles (38) s'étend entièrement à travers ladite paroi inférieure depuis sa surface supérieure jusqu'à la surface inférieure et s'étend en outre au moins jusqu'à l'une des surfaces latérales.

6. Assemblage de support de puce à circuit intégré selon l'une quelconque des revendications précédentes dans lequel ledit support comporte une pluralité de parois verticales (78, 80, 82, 84) connectées à ladite paroi inférieure de celui-ci et s'étendant à partir de celle-ci pour définir un creux (86) pour puce afin de recevoir et de protéger la puce à circuit intégré.

7. Assemblage de support de puce à circuit intégré selon la revendication 6 dans lequel le couvercle (36) comporte une paroi supérieure (120) et une pluralité de parois latérales (122, 124, 126, 128) s'étendant à partir de ladite paroi supérieure et reliées à celle-ci, lesdites parois latérales dudit couvercle étant disposées pour être placées généralement en coopération télescopique avec les parois verticales dudit support, de telle sorte que la coopération par verrouillage du couvercle et du support renferme sensiblement une puce montée dans le creux pour puce dudit support.

8. Assemblage de support de puce à circuit intégré selon la revendication 7 dans lequel le couvercle comporte une pluralité de bras de verrouillage de support (130, 132, 134, 136) connectés à celui-ci et s'étendant à partir de celui-ci, lesdits bras de verrouillage de support étant disposés pour faire coopérer par verrouillage ledit couvercle avec ledit support pour définir un sous-assemblage enfichable.

9. Assemblage de support de puce à circuit intégré selon la revendication 8 dans lequel lesdits bras de verrouillage de sous-assemblage (142, 144) comportent chacun une rebord de verrouillage 156, 158) pouvant s'engager avec les moyens de verrouillage de ladite embase, et comportent en outre des moyens d'actionnement (152, 154) pour faire tourner les rebords de verrouillage en s'éloignant l'un de l'autre en se libérant de ladite embase, pour libérer ledit support, le sous-assemblage de ladite embase.

10. Assemblage de support de puce à circuit intégré selon l'une quelconque des revendications précédentes dans lequel ledit support et ladite embase comportent des moyens de polarisation (60, 88) pour assurer une orientation appropriée de l'un par rapport à l'autre.

11. Assemblage de support de puce à circuit intégré selon l'une quelconque des revendications précédentes dans lequel chacune desdites bornes de support (40) comporte une paire de pattes de contact en porte à faux et opposées (112, 114) s'étendant dans la seconde partie femelle (108) de celles-ci pour obtenir un contact électrique redondant à double face avec les broches (62) de ladite embase.

12. Assemblage de support de puce à circuit intégré selon la revendication 11 dans lequel les pattes de contact (112, 114) de ladite seconde partie femelle sont de différentes longueurs respectives.

13. Assemblage de support de puce à circuit intégré selon l'une quelconque des revendications précédentes dans lequel chacune desdites bornes de support de type tubulaire est formée à partir d'une pièce unitaire de matériau électriquement conducteur et comporte une première paroi (100), une seconde paroi (104) et une paroi intermédiaire (102) disposée entre lesdites première et seconde parois et généralement parallèle à celles-ci, une première paroi d'extrémité (96) reliée auxdites parois intérieure et extérieure et s'étendant orthogonalement entre celles-ci et une seconde paroi d'extrémité (98) reliée à ladite première paroi et à ladite paroi intermédiaire et s'étendant entre celles-ci de telle sorte que ladite première partie de douille femelle (106) est définie par ladite paroi intermédiaire, ladite seconde paroi et une partie de ladite première paroi d'extrémité, et dans lequel la seconde partie femelle (108) de celle-ci est définie par ladite première paroi, ladite paroi intermédiaire, ladite seconde paroi d'extrémité et une partie de ladite première paroi d'extrémité.

14. Assemblage de support de puce à circuit intégré selon la revendication 13, dans lequel chacune desdites bornes de support comporte une patte de contact en porte à faux (116) s'étendant à partir de ladite paroi intermédiaire (102) dans sa première partie femelle (106), pour pousser l'un desdits conducteurs (58) de puce à circuit intégré en contact avec ladite seconde paroi (104) de ladite borne de support.

15. Assemblage de support de puce à circuit intégré selon la revendication 14 dans lequel la seconde paroi (104) de chacune desdites bornes de support est caractérisée par une ouverture (118) généralement alignée avec la patte de contact s'étendant dans sa première partie femelle, ladite ouverture facilitant le soudage sans vapeur dudit conducteur de puce à circuit intégré à ladite borne de support.

16. Borne femelle double de type tubulaire (40) pour connecter un conducteur (58) de puce à circuit intégré à une broche conductrice électriquement (62), ladite borne étant formée à partir d'une pièce unitaire de matrice de matériau conducteur électriquement formée pour définir des première et seconde parois (100, 104) généralement parallèles, une paroi intermédiaire (102) parallèle auxdites première et seconde parois, une première paroi d'extrémité (96) connectée à ladite première paroi et à ladite paroi intermédiaire et s'étendant orthogonalement entre celles-ci et une seconde paroi d'extrémité (98) connectée à ladite première paroi et à ladite praoi intermédiaire et s'étendant entre celles-ci, ladite seconde paroi et une partie de ladite première paroi d'extrémité définissant une première partie de douille femelle (106) de ladite borne, et de telle sorte que la première paroi, ladite paroi intermédiaire, ladite seconde paroi d'extrémité et une partie de ladite première paroi d'extrémité définissent une seconde partie femelle (108) de ladite borne.

17. Borne selon la revendication 16 comportant en outre des pattes de contact en porte à faux (112, 114) s'étendant l'une vers l'autre et dans ladite seconde partie femelle de ladite borne à partir des première et seconde parois d'extrémité respectivement.

18. Borne selon la revendication 17 dans laquelle les première et seconde pattes de contact s'étendant dans ladite seconde partie femelle sont de différentes longueurs respectives.

19. Borne selon la revendication 16 comprenant une patte de contact en porte à faux (116) s'étendant à partir de ladite paroi intermédiaire de manière convexe dans ladite première partie femelle de ladite borne pour pousser un conducteur de puce à circuit intégré en contact avec ladite seconde paroi de ladite borne.

20. Borne selon la revendication 19 dans laquelle la seconde paroi de ladite borne est caractérisée par une ouverture (118) généralement alignée avec la patte de contact s'étendant dans la première partie femelle de celle-ci pour faciliter le soudage sans vapeur d'un conducteur de puce à circuit intégré à ladite borne.

21. Borne selon la revendication 20 dans laquelle les parties opposées de ladite seconde paroi et ladite patte de contact s'étendant dans ladite première partie femelle sont plaquées avec de la soudure.
